**Europäisches Patentamt**

**European Patent Office**

**Office européen des brevets**

(19)

(11) Veröffentlichungsnummer : **0 061 648**
**B1**

(12) **EUROPÄISCHE PATENTSCHRIFT**

(45) Veröffentlichungstag der Patentschrift :
30.01.85

(21) Anmeldenummer : 82102122.7

(22) Anmeldetag : 16.03.82

(51) Int. Cl.⁴ : **H 03 H 9/64, H 03 H 3/08**

(54) **Elektrisches Bauelement, dessen aktiver Teil auf einem Metallträger aufgebracht ist, und Verfahren zur Herstellung des Bauelementes.**

(30) Priorität : 27.03.81 DE 3112235

(43) Veröffentlichungstag der Anmeldung :
06.10.82 Patentblatt 82/40

(45) Bekanntmachung des Hinweises auf die Patenterteilung : 30.01.85 Patentblatt 85/05

(84) Benannte Vertragsstaaten :
DE FR GB IT

(56) Entgegenhaltungen :
EP-A- 0 023 109
DE-A- 2 610 172
DE-A- 3 048 817
US-A- 3 270 252
PATENTS ABSTRACTS OF JAPAN, Band 5, Nr.121, 5.
August 1981, Seite E-68 (793)

(73) Patentinhaber : **Siemens Aktiengesellschaft**
**Berlin und München Wittelsbacherplatz 2**
**D-8000 München 2 (DE)**

(72) Erfinder : **Pilz, Dieter, Dipl.-Ing.**
**Zugspitzstrasse 6**
**D-8039 Puchheim (DE)**
Erfinder : **Scheffler, Horst**
**Friedrich-Engelsbogen 18**
**D-8000 München 83 (DE)**
Erfinder : **Stelzl, Hans**
**Rotkelchenweg 4**
**D-8011 Vaterstetten (DE)**
Erfinder : **Wagmann, Walter**
**Haidgraben 93**
**D-8012 Ottobrunn (DE)**

**Beschreibung**

Die Erfindung betrifft ein z. B. in der EP-A-23 109, veröffentlicht am 28.1.1981, beschriebenes elektrisches Bauelement, dessen aktiver Teil auf einem Metallträger aufgebracht ist, insb. Oberflächenwellenfilter mit wenigstens einem Eingangs- und wenigstens einem Ausgangswandler auf der einen Seite eines insb. einkristallinen piezoelektrischen Körpers, als aktiver Teil, der mit seiner anderen Seite auf dem elektrisch an Masse anzuschließenden Metallträger befestigt ist, an dessen einer Längsseite und in etwa gleicher Ebene verlaufend wenigstens eine Anschlußfahne für diesen Massenanschluß und weitere, elektrisch und mechanisch getrennte Anschlußfahnen für die Stromzuleitung zu bzw. Stromableitung von dem aktiven Teil über Verbindungsdrähte vorhanden sind, der aktive Teil, insb. der piezoelektrische Körper, der Metallträger und die Verbindungsdrähte in einem Gehäuse untergebracht sind, dessen Öffnung mit einem Kunststoffteil und mit Kleb- und/oder Vergußmaterial verschlossen ist und die Anschlußfahnen durch den Kunststoffteil hindurch nach außen ragen.

Die Erfindung betrifft ferner ein Verfahren zur Herstellung eines solchen Bauelementes bei dem die Metallträger samt Anschlußfahnen zunächst aus einem zusammenhängenden Metallband derart ausgestanzt werden, daß der Zusammenhalt mehrerer Metallträger durch einen Grundstreifen, mit dem die Anschlußfahnen verbunden bleiben, und durch Verbindungsstücke, die zusammen mit der Anschlußfahne für den Masseanschluß die Verbindung zwischen Metallträger und den Anschlußfahnen ergeben, gewährleistet ist, wonach der Kunststoffteil um die inneren Anschlußteile der Anschlußfahnen und um Metallstreifen an Metallträger zu den Verbindungsstücken geformt wird, vorher oder danach der aktive Teil an den Metallträger befestigt und entsprechend mittels Drähten mit den inneren Anschlußteilen elektrisch verbunden wird, dann die Verbindungsstücke entfernt, das Gehäuse auf den Kunststoffteil aufgesetzt und mit ihm durch Kleb- und/oder Vergußmaterial verbunden und dicht verschlossen wird, und schließlich die Anschlußfahnen in entsprechender Länge vom Grundstreifen abgetrennt werden.

Elektrische Bauelemente, auf die sich die vorliegende Erfindung bezieht, sind passive und aktive Bauelemente, (Widerstände, Kondensatoren, Induktivitäten, Relais, Dioden, Transistoren), Bauelementegruppen (auf eine Platine aufgetragene, miteinander verschaltete passive und/oder aktive elektrische Bauelemente), integrierte Schaltungen und insb. elektrische Oberflächenwellenfilter.

Passive und aktive elektrische Bauelemente sind hinreichend bekannt. Ebenso Bauelementegruppen der oben erläuterten Art.

Integrierte Schaltungen, z. B. Operationsverstärker, sind beispielsweise in dem Buch der Fa. Siemens : « Bauelemente, technische Erläuterungen und Kenndaten für Studierende », 2. Auflage, 1977, auf Seite 186 beschrieben.

Elektrische Oberflächenwellenfilter der geschilderten Art sind beispielsweise in der US-PS 3 836 876, in der DE-AS 28 45 610 und in der Zeitschrift « Siemens Components » 18. Jahrgang, Heft 4, August 1980, Seiten 167 bis 169 dargestellt und beschrieben.

Bei den hier in Rede stehenden elektrischen Oberflächenwellenfiltern handelt es sich um solche, die senkrecht stehend auf eine gedruckte Schaltungsplatte einbaubar sind, indem die Anschlußfahnen in der Ebene des Metallträgerkörpers aus dem Gehäuse herausragen, wie dies in der genannten Zeitschrift « Siemens Components » erläutert ist.

Eine andere Art der Einbauweise elektrischer Oberflächenwellenfilter in gedruckte Schaltungen sieht vor, daß die Anschlußfahnen des Metallträgerkörpers um einen Winkel von 90° in einer Richtung hin abgebogen sind, so daß das Oberflächenwellenfilter parallel zur Oberfläche der gedruckten Schaltungsplatte nach dem Einbau angeordnet ist. Ein solches Oberflächenwellenfilter ist in der Zeitschrift « Siemens Components » 18. Jahrgang, 1980, Heft 1, Seiten 44 und 45 gezeigt.

Andere Ausführungsformen von Oberflächenwellenfiltern für waagerechten Einbau sind in der DE-US 26 09 884 (prioritätsgleich mit US-PS 4 047 129) und in der DE-AS 26 10 172 (prioritätsgleich mit US-PS 4 034 318) beschrieben.

Es ist andererseits hinreichend bekannt, elektrische Bauelemente, auf die sich die vorliegende Erfindung bezieht — mit Ausnahme von Oberflächenwellenfiltern — zum Zwecke der Abschirmung in Metallgehäuse einzubauen. In aller Regel bestehen solche Metallgehäuse aus einem Becher runden oder rechteckigen Querschnittes und einem Metalldeckel, durch den hindurch Anschlußstifte — isoliert mittels Glasperlen oder anderen isolierenden Materialien — hindurchgeführt sind. Der Anschluß an Masse solcher Gehäuse geschieht über einen Anschlußstift, der mit dem Deckel und/oder dem Becher des Metallgehäuses galvanisch verbunden ist.

Die Herstellung solcher Abschirmmetallgehäuse ist sowohl im Hinblick auf das Material als auch im Hinblick auf die aufzuwendende Arbeitsleistung sehr kostenaufwendig und deshalb für elektrische Bauelemente, die in sehr hohen Stückzahlen (einige Millionen pro Jahr) hergestellt werden müssen, nicht anwendbar.

Elektrische Bauelemente für die Elektronik, auf die sich die vorliegende Erfindung bezieht, wie insb. Oberflächenwellenfilter werden kostengünstig auf praktisch ebenen metallischen Trägerelementen, sog. Spinnen, aufgebaut, wobei das eigentliche Bauteil, nämlich der aktive Teil des elektrischen Bauelementes, der beispielsweise ein chip sein kann, auf einem ebenen oder speziell geformten Metallträger, der z. B. eine wannenförmige Vertiefung aufweist, befestigt wird. Die Anschlüsse des aktiven Bauteiles werden mit an einer Seite des Metallträgers angeordneten Anschlußfahnen der Spinne mittels zusätzlicher Drähte verbunden. Die Anschlußteile werden mittels eines Kunststoffteiles zusammengehalten. Eine oder mehrere der Anschlußfahnen können auch sowohl aus Gründen der elektrischen Abschirmung, als auch zur mechanischen Stabilisierung mit dem Trägerblech galvanisch verbunden sein. Das vollständig montierte elektrische Bauelement wird zum Schutz gegen mechanische und klimatische Einflüsse mit einem Kunststoffbecher abgedeckt und mit dem genannten Kunststoffteil z. B. durch Kleben oder mittels Vergußmasse verbunden. Aus Gründen der besseren elektromagnetischen Abschirmung empfiehlt es sich, anstelle des Kunststoffgehäuses (Kunststoffbechers) ein Metallgehäuse zu verwenden, wobei dieses mit dem Metallträger des aktiven Teiles galvanisch verbunden sein muß.

Hier setzt die vorliegende Erfindung ein und hat zur Aufgabe, daß die galvanische Verbindung zwischen Metallträger und Metallgehäuse direkt am Bauelement erfolgt und nicht erst auf der eine gedruckte Schaltung tragenden Platine, weil die Abschirmwirkung um so besser ist, je kleiner die Stromschleifen sind, weil die elektrischen Meßwerte des Bauelementes weitgehend von der Meßfassung bzw. von der Platine unabhängig sind, weil das Metallgehäuse nicht mit einem lötfähigen Anschlußbein versehen sein muß wegen der damit verbundenen erhöhten Material- und Verarbeitungskosten und weil der Anwender des elektrischen Bauelementes keine zusätzlichen Vorkehrungen in der gedruckten Schaltung treffen muß.

Zur Lösung dieser Aufgabe ist das elektrische Bauelement der eingangs angegebenen Art erfindungsgemäß dadurch gekennzeichnet, daß das Gehäuse aus Metall besteht, dessen Öffnung den Kunststoffteil überragt, und daß der Metallträger an wenigstens einem Ende der Längsseite in eine Anschlußfahne übergeht, die außerhalb des Kunststoffteiles mit dem überragenden Teil des Metallgehäuses durch Schweiß- oder Lötverbindung galvanisch verbunden ist.

Für eine gute Verbindung zwischen der wenigstens einen Anschlußfahne und dem Metallgehäuse ist es vorteilhaft, daß die an der Anschlußfahne bei ihrer Herstellung erzeugte Trennstelle stumpf an der Innenwand des Metallgehäuses anliegt oder höchstens einen Abstand von 0,2 mm von der Innenwand hat.

Zur Erzeugung einer Verbindungsstelle zwischen Anschlußfahne und Metallgehäuse, die weder das Gehäuse beim Schweißen zu stark angreift noch zu einem Überstehen der Anschlußfahne führt, ist es vorteilhaft, daß die wenigstens eine Anschlußfahne den Rand des Metallgehäuses vor dem Verschweißen um 0,1 bis 0,3 mm überragt. Bei diesem Ausmaß des Überragens bewirkt der beim Schweißen entstehende Lichtbogen, daß der überstehende Teil der Anschlußfahne abgetragen wird, dabei aber das Metallgehäuse im wesentlichen an der Schweißstelle nicht verformt wird.

Die Metalle für Metallträger und Metallgehäuse sind vorzugsweise aus der Gruppe Kupfer, Eisen, Aluminium, Zink, Nickel bzw. Legierungen dieser Materialien im Hinblick auf gute gegenseitige Schweißbarkeit auszuwählen.

Das Verfahren zur Herstellung eines elektrischen Bauelementes der in der Einleitung beschriebenen Art ist zur Lösung der Aufgabe erfindungsgemäß dadurch gekennzeichnet, daß der Übergang von den Metallstreifen des Metallträgers zu den Verbindungsstücken beim Ausstanzen und beim Entfernen der Verbindungsstücke so geformt wird, daß Anschlußfahnen entstehen, die zur Innenwand des Metallgehäuses gerichtet und an ihr nach Aufsetzen des Metallgehäuses stumpf anliegen oder höchstens in einem Abstand von 0,2 mm von ihr stehen, wonach die elektrische Verbindung zwischen Metallgehäuse und den Anschlußfahnen durch Schweißung oder Lötung erfolgt.

Vorzugsweise werden die Anschlußfahnen so ausgestanzt, daß sie den Rand des Metallgehäuses um 0,1 bis 0,3 mm überragen und beim Schweißen abschmelzen und die Verbindung zum Metallgehäuse ergeben.

Die Erfindung wird nachfolgend und unter Bezugnahme auf die Zeichnungen näher erläutert.

Es zeigen

Figur 1   einen teilweisen Schnitt längs der Linie I-I in Fig. 2 durch ein Bauelement, im vorliegenden Fall ein Oberflächenwellenfilter ;

Figur 2   einen Schnitt gemäß der Linie II-II in Fig. 1 des gleichen Bauelementes ;

Figur 3   einen Ausschnitt, der das Herstellungsverfahren verdeutlicht ;

Figur 4   ebenfalls einen Ausschnitt zur Erläuterung des Herstellungsverfahrens mit einer anderen Form der ausgestanzten Metallelemente.

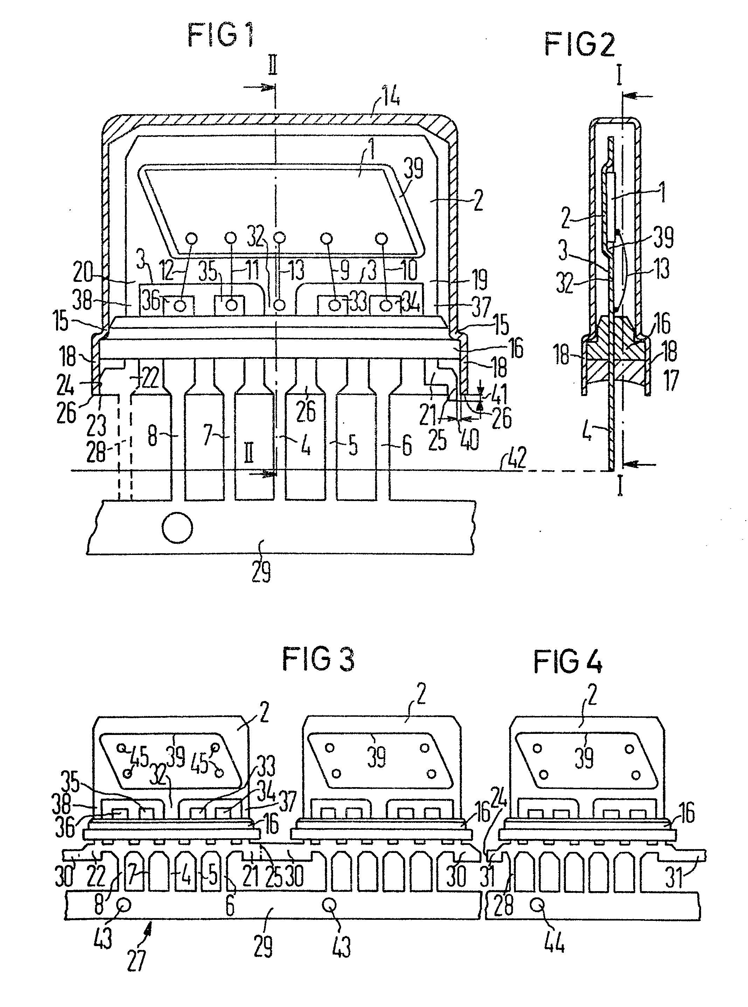

In Fig. 1 ist mit 1 der aktive Teil des elektrischen Bauelementes, im vorliegenden Fall eine piezoelektrische einkristalline Platte — üblicherweise aus Lithiumniobat bestehend — gezeigt. Die verschiedenen Wandlerelektroden und Kopplerteile sind aus Gründen der Übersichtlichkeit hier nicht dargestellt.

Der aktive Teil 1 ist auf einem Metallträger 2 befestigt, der zu diesem Zweck vorzugsweise mit einer wannenförmigen Vertiefung versehen ist. Die Rückseite des aktiven Teiles 1 ist beispielsweise durch Klebverbindung mit dem Metallträger 2 verbunden.

An der Längsseite 3 des Metallträgers 2 sind Anschlußfahnen 4 bis 8 vorhanden, die in gleicher Ebene wie der Metallträger 2 verlaufen. Die Anschlußfahne 4 ist mit dem Metallträger 2 aus einem Stück bestehend hergestellt, d. h. ihr innerer Anschlußteil 32 geht in den Metallträger 2 über.

Der innere Teil 32 der Anschlußfahne 4 und die inneren Teile 33 bis 36 der Anschlußfahnen 5 bis 8 sind durch Drähte 9 bis 13 mit den jeweiligen Anschlußstellen des aktiven Teiles 1 verbunden. Die Drähte können dabei in an sich bekannter Weise durch Thermokompression an den jeweiligen Stellen befestigt

3

werden. Am rechten Ende 19 und gegebenenfalls auch am linken Ende 20 der Längsseite 3 des Metallträgers 2 sind Metallstreifen 37 und 38 vorgesehen, die in Anschlußfahnen 21 und 22 übergehen.

Es genügt an sich, wenn nur eine solche Anschlußfahne 21 vorhanden ist. Es kann aber auch eine weitere Anschlußfahne 22 vorhanden sein, die gegebenenfalls auch in eine weitere Anschlußfahne 28 übergeht (in Fig. 1 deshalb gestrichelt gezeichnet), so daß ein Masseanschluß nicht bloß über die Anschlußfahne 4, deren inneren Anschlußteil 32 und den Draht 13 gewährleistet ist, sondern daß auch der Metallträger 2 über den Metallstreifen 38, die Anschlußfahne 22 und die weitere Anschlußfahne 28 an Masse anschließbar ist.

Das aus Metall bestehende Gehäuse 14 ist über den gesamten aktiven Teil 1, den Metallträger 2, die Zuleitungsdrähte 9 bis 13, die inneren Anschlußteile 32 bis 36 und einen Kunststoffteil 16 gestülpt, wofür das Metallgehäuse 14 dem Kunststoffteil 16 angepaßte Abknickungen 15 aufweist, damit ein guter und dichter Verschluß gewährleistet ist. Die Abknickungen 15 gehen in einen den Kunststoffteil 16 überragenden Teil 18 über, so daß ein Hohlraum entsteht, der entweder mit Klebmaterial oder — wie im vorliegenden Fall (Fig. 2) — mit Vergußmasse 17 ausgefüllt wird, so daß ein hermetischer Verschluß resultiert.

Die Anschlußfahnen 4 bis 8, 21 und 22 sind fest in den Kunststoffteil 16 eingebettet.

Im linken Teil von Fig. 1 ist gezeigt, daß die Anschlußfahne 22 mit ihrer Trennstelle 24 stumpf am den Kunststoffteil 16 überragenden Teil 18 des Metallgehäuses 14 anliegt und daß durch eine Löt- oder vorzugsweise Schweißverbindung 23 der galvanische Kontakt zwischen Metallträger 2 und Metallgehäuse 14 gewährleistet ist.

Im rechten Teil von Fig. 1 ist die Anordnung der Anschlußfahne 21 gegenüber dem überragenden Teil 18 vor der Herstellung der Schweißverbindung gezeigt. Die Trennstelle 25 ist durch entsprechende gegenseitige Bemessung von Gehäuse und Anordnung der Anschlußfahnen in einem Abstand 40 zwischen der Trenstelle 25 und dem überragenden Teil 18 angeordnet. Dieser Abstand 40 soll 0,2 mm nicht übersteigen.

Ferner ist im rechten Teil von Fig. 1 gezeigt, daß die Anschlußfahne 21 den oberen Rand 26 des Metallgehäuses 14 um eine Länge 41 überragt. Diese Länge 41 soll vorzugsweise zwischen 0,1 und 0,3 mm betragen, weil dieser Wert ausreichend ist, um beim Schweißvorgang zur Bildung der Schweißverbindung 23 abgetragen zu werden.

Die galvanische Verbindung zwischen den Anschlußfahnen 21 und 22 und dem Teil 18 des Metallgehäuses 14 erfolgt vorzugsweise durch sogenanntes Widerstands-Inertgas-Schweißen. Dabei werden Metallgehäuse 14 und Metallträger 2 auf Erdpotential gelegt, und von einer in geringem Abstand zur vorgesehenen Verbindungsstelle 23 stehenden Schweißelektrode, die entsprechend aufgeladen ist, springt ein elektrischer Funke auf die Anschlußfahne über, 21 und/oder 22, schmilzt diese nieder, so daß über den entstehenden Wärmekontakt auch eine kleine Zone am Rand des Metallgehäuses 14 aufschmilzt und so nach Abkühlen der Schmelze eine mechanische feste galvanische Verbindung entsteht.

Es können an beiden Enden des Metallträgers 2 Anschlußfahnen 21 und 22 vorhanden sein und durch Schweißverbindung 23 mit dem Metallgehäuse 14 verbunden sein. Es kann aber auch nur an einem Ende eine solche Schweißverbindung 23 hergestellt werden.

Die Anschlußfahnen 4 bis 8 und ggf. 28 werden längs der Trennlinie 42 vom Metallband abgetrennt. Dieser Vorgang hängt mit dem Herstellungsverfahren gemäß der vorliegenden Erfindung zusammen und wird nachfolgend anhand der Fig. 3 und 4 beschrieben.

Ein elektrisches Bauelement gemäß der Erfindung wird vorzugsweise durch ein Verfahren hergestellt, bei dem die Metallträger 2 samt Anschlußfahnen 4 bis 8 und ggf. 28 zunächst aus einem zusammenhängenden Metallband 27 derart ausgestanzt werden, daß der Zusammenhalt mehrerer Metallträger 2 durch einen Grundstreifen 29 gewährleistet ist. Die Anschlußfahnen 4 bis 8 und ggf. 28 bleiben mit dem Grundstreifen 29 verbunden, und durch Verbindungsstücke 30 und 31 wird, zusammen mit den Anschlußfahnen 4, ggf., 28 für den Masseanschluß die Festigkeit des Metallbandes gewährleistet.

Die Anschlußfahnen 4 bis 8 und ggf. 28 (Fig. 4) werden zusammen in einem Stanzvorgang, bei dem auch die inneren Anschlußteile 32 bis 36 gebildet werden, hergestellt. Dadurch, daß der innere Anschlußteil 32 der Anschlußfahne 4 mit dem Metallträger 2 verbunden bleibt und die Metallstreifen 37 und 38, die zu den Anschlußfahnen 21 und 22 führen, ebenfalls mit dem Metallträger verbunden sind, sowie ferner durch die Verbindungsstücke 30 bzw. 31 bleibt der gesamte Metallstreifen 27 zusammenhängend und kann in einer automatischen Vorrichtung gleichzeitig als Transportband verwendet werden, wofür die Löcher 43 und 44 der Zentrierung und dem Transporteingriff dienen.

Beim Ausstanzvorgang wird dafür gesorgt, daß die Anschlußfahnen 21 und 22 derart entstehen, daß sie später mit ihren Trennstellen (siehe Fig. 1) am Metallgehäuse 14 anliegen oder im angegebenen Höchstabstand davon angeordnet sind.

Der Kunststoffteil 16 wird um die inneren Anschlußteile 32 bis 36 der Anschlußfahnen 4 bis 8 und um die Metallstreifen 37 und 38 am Metallträger 2, die zu den Verbindungsstücken 30 und 31 führen, geformt.

Vorher oder danach wird der aktive Teil an den Metallträger 2 befestigt. Damit insb. bei Oberwellenflächenfiltern unerwünschte Schwingungen unterdrückt werden, sind in der wannenförmigen Vertiefung 39 Metallträger 2 mit Abstandnoppen angeordnet, beispielsweise wie dies in der DE-OS 28 45 610 beschrieben ist.

Die in Fig. 1 gezeigten Drähte 9 bis 13 oder auch andere Übergangsanschlüsse zu den inneren Anschlußteilen der Anschlußfahnen werden dann zum Zwecke der elektrischen Verbindung beispielsweise durch Thermokompression — wie an sich bekannt — angebracht.

Danach werden die Verbindungsstücke 30 bzw. 31 so entfernt, daß Trennstellen 25 entstehen (Fig. 1).

Auf die derart vorbereiteten Anordnungen werden dann die Metallgehäuse 14 während des automatischen Herstellungsprozesses aufgesetzt, und es wird — wie oben beschrieben — die Schweiß — oder Lötverbindung 23 hergestellt.

Bereits zu diesem Zeitpunkt oder auch nach dem Abtrennen der Anschlußfahnen 4 bis 8 und ggf. 28 längs der Linie 42 wird der Verschluß mittels Kleb- und/oder Vergußmaterial 17 erzeugt.

Aus Gründen des Einsatzes von elektrischen Bauelementen gemäß der vorliegenden Erfindung in automatischen Bestückungsvorrichtungen für gedruckte Schaltungen kann es vorteilhaft sein, mehrere solche elektrische Bauelemente am Grundstreifen 29 zu belassen und die Abtrennung längs der Linie 42 erst im Rahmen der Bestückung der gedruckten Schaltung vorzunehmen.

## Bezugszeichenliste

1. Aktiver Teil des el. Bauelementes, hier piezoelektr. Körper
2. Metallträger (zusammen mit den Anschlußfahnen 4 bis 8 auch Spinne genannt)
3. Längsseite des Metallträgers
4. Anschlußfahne für Masseanschluß
5. Anschlußfahne
6. Anschlußfahne
7. Anschlußfahne
8. Anschlußfahne
9. Verbindungsdraht
10. Verbindungsdraht
11. Verbindungsdraht
12. Verbindungsdraht
13. Verbindungsdraht
14. Gehäuse (aus Metall)
15. Öffnung im Gehäuse 14
16. Kunststoffteil
17. Kleb- und/oder Vergußmaterial
18. Teil des Metallgehäuses 14, der den Kunststoffteil 16 überragt
19. Ende der Längsseite 3
20. Ende der Längsseite 3
21. Anschlußfahne
22. Anschlußfahne
23. Schweiß- oder Lötverbindung
24. Trennstelle
25. Trennstelle
26. Rand des Metallgehäuses 14
27. Metallband
28. Anschlußfahne an der Anschlußfahne 22
29. Grundstreifen
30. Verbindungsstück
31. Verbindungsstück
32. innerer Anschlußteil der Masseanschlußfahne 4
33. innerer Anschlußteil der Anschlußfahne 5
34. innerer Anschlußteil der Anschlußfahne 6
35. innerer Anschlußteil der Anschlußfahne 7
36. innerer Anschlußteil der Anschlußfahne 8
37. Metallstreifen am Metallträger 2
38. Metallstreifen am Metallträger 2
39. Wannenförmige Vertiefung im Metallträger 2
40. Abstand zwischen Anschlußfahne (z. B. 21) und Teil 18
41. Länge, um die die Anschlußfahne (z. B. 21) den Rand 26 überragt
42. Trennlinie, längst der die Anschlußfahnen vom Metallband 27 abgetrennt werden.
43. Zentrier- und Transporteingrifflöcher
44. Zentrier- und Transporteingrifflöcher
45. Abstandnoppen

## Ansprüche

1. Elektrisches Bauelement, dessen aktiver Teil (1) auf einem Metallträger (2) aufgebracht ist, insb.

Oberflächenwellenfilter mit wenigstens einem Eingangs- und wenigstens einem Ausgangswandler auf der einen Seite eines insb. einkristallinen piezoelektrischen Körpers (1) als aktiver Teil, der mit seiner anderen Seite auf dem elektrisch an Masse anzuschließenden Metallträger (2) befestigt ist, an dessen einer Längsseite (3) und in gleicher Ebene verlaufend wenigstens eine Anschlußfahne (4) für diesen Massenanschluß und weitere, elektrisch und mechanisch getrennte Anschlußfahnen (5 bis 8) für die Stromzuleitung zu bzw. Stromableitung von dem aktiven Teil (1) über Verbindungsdrähte (9 bis 12) vorhanden sind, der aktive Teil, insb. der piezoelektrische Körper (1), der Metallträger (2) und die Verbindungsdrähte (9 bis 13) in einem Gehäuse (14) untergebracht sind, dessen Öffnung (15) mit einem Kunststoffteil (16) und mit Kleb- und/oder Vergußmaterial (17) verschlossen ist, und die Anschlußfahnen (4 bis 8) durch den Kunststoffteil (16) hindurch nach außen ragen, dadurch gekennzeichnet, daß das Gehäuse (14) aus Metall besteht, dessen Öffnung (15) den Kunststoffteil (16) überragt, und daß der Metallträger (2) an wenigstens einem Ende (19, 20) der Längsseite (3) in eine Anschlußfahne (21, 22) übergeht, die außerhalb des Kunststoffteiles (16) mit dem überragenden Teil (18) des Metallgehäuses (14) durch Schweiß- oder Lötverbindung (23) galvanisch verbunden ist.

2. Elektrisches Bauelement nach Anspruch 1, dadurch gekennzeichnet, daß die wenigstens eine Anschlußfahne (21, 22) so bemessen ist, daß ihre bei der Herstellung erzeugte Trennstelle (24, 25) stumpf an der Innenwand des Metallgehäuses (14) anliegt oder höchstens einen Abstand von 0,2 mm von der Innenwand hat.

3. Elektrisches Bauelement nach Anspruch 1 oder 2, dadurch gekennzeichnet, daß die wenigstens eine Anschlußfahne (21, 22) den Rand (26) des Metallgehäuses (14) vor dem Verschweißen um 0,1 bis 0,3 mm überragt.

4. Elektrisches Bauelement nach einem der Ansprüche 1 bis 3, dadurch gekennzeichnet, daß wenigstens eine Anschlußfahne (21, 22) mit einer Verlängerung versehen ist, die als weitere Anschlußfahne (28) für den Masseanschluß dient.

5. Elektrisches Bauelement nach einem der Ansprüche 1 bis 4, dadurch gekennzeichnet, daß die Metalle für Metallträger (2) und Metallgehäuse (14) aus der Gruppe Kupfer, Eisen, Aluminium, Zink, Nickel bzw. Legierungen dieser Materialien im Hinblick auf gute gegenseitige Schweißbarkeit ausgewählt sind.

6. Verfahren zur Herstellung eines elektrischen Bauelementes nach einem der Ansprüche 1 bis 5, bei dem die Metallträger (2) samt Anschlußfahnen (4 bis 8 und 28) zunächst aus einem zusammenhängenden Metallband (27) derart ausgestanzt werden, daß der Zusammenhalt mehrerer Metallträger (2) durch einen Grundstreifen (29), mit dem die Anschlußfahnen (4 bis 8 und 28) verbunden bleiben, und durch Verbindungsstücke (30, 31), die zusammen mit der Anschlußfahne (4) für den Masseanschluß die Verbindung zwischen Metallträger (2) und den Anschlußfahnen (5 bis 8 und 28) ergeben, gewährleistet ist, wonach der Kunststoffteil (16) um die inneren Anschlußteile (32 bis 36) der Anschlußfahnen (4 bis 8) und um Metallstreifen (37, 38) am Metallträger (2) zu den Verbindungsstücken (30, 31) geformt wird, vorher oder danach der aktive Teil (1) an den Metallträger (2) befestigt und entsprechend mittels Drähten (9 bis 13) mit den inneren Anschlußteilen (32 bis 36) elektrisch verbunden wird, dann die Verbindungsstücke (30, 31) entfernt werden, das Gehäuse (14) auf den Kunststoffteil (16) aufgesetzt und mit ihm durch Kleb- und/oder Vergußmaterial (17) verbunden und dicht verschlossen wird, und schließlich die Anschlußfahnen (4 bis 8 und 28) in entsprechender Länge vom Grundstreifen (29) abgetrennt werden, dadurch gekennzeichnet, daß der Übergang von den Metallstreifen (37, 38) des Metallträgers (2) zu den Verbindungsstücken (30, 31) beim Ausstanzen und beim Entfernen der Verbindungsstücke (30, 31) so geformt wird, daß Anschlußfahnen (21, 22) entstehen, die zur Innenwand des Metallgehäuses (14) gerichtet und an ihr nach Aufsetzen des Metallgehäuses (14) stumpf anliegen oder höchstens in einem Abstand von 0,2 mm von ihr stehen, wonach die elektrische Verbindung (23) zwischen Metallgehäuse (14) und den Anschlußfahnen (21, 22) durch Schweißung oder Lötung erfolgt.

7. Verfahren nach Anspruch 6, dadurch gekennzeichnet, daß die Anschlußfahnen (21, 22) so lang ausgestanzt werden, daß sie den Rand (26) des Metallgehäuses (14) um 0,1 bis 0,3 mm überragen und beim Schweißen abschmelzen und die Verbindung (23) zum Metallgehäuse (14) ergeben.

**Claims**

1. An electrical component, the active part (1) of which is arranged on a metal carrier (2), in particular a surface wave filter having at least one input transducer and at least one output transducer on one side of a piezoelectric body (1), which in particular is monocrystalline, as the active part, and which at its other side is attached to the metal carrier (2) which is to be electrically connected to earth, and on the one longitudinal side (3) of which and in the same plane there are arranged at least one terminal lug (4) for this earth terminal, and additional, electrically and mechanically isolated terminal lugs (5 to 8) for the current supply to, and current discharge from, the active part (1) by way of connection wires (9 to 12), the active component, in particular the piezoelectric body (1), the metal carrier (2) and the connection wires (9 to 13) being accommodated in a housing (14) the opening (15) of which is closed by a synthetic resin component (16) and by adhesive and/or casting material (17), and the terminal lugs (4 to 8) projecting outwardly through the synthetic resin component (16), characterised in that the housing (14) consists of metal and the opening (15) therein projects beyond the synthetic resin component (16) ; and that least one end (19, 20) of the longitudinal side (3) of the metal carrier (2) continues into a terminal lug (21, 22) which, outside the synthetic resin component (16), is d.c.-connected to the projecting part (18) of the metal housing (14) by a welded or soldered connection (23).

2. An electrical component as claimed in Claim 1, characterised in that at least one terminal lug (21, 22) is so designed that its separation point (24, 25), which is formed during production, abuts against the inner wall of the metal housing (14) or has not most a spacing of 0.2 mm from the inner wall.

3. An electrical component as claimed in Claim 1 or 2, characterised in that at least one terminal lug (21, 22) projects beyond the edge (26) of the metal housing (14), prior to welding by 0.1 to 0.3 mm.

4. An electrical component as claimed in one of Claims 1 to 3, characterised in that at least one terminal lug (21, 22) is provided with an extension which serves as an additional terminal lug (28) for the earth terminal.

5. An electrical component as claimed in one of Claims 1 to 4, characterised in that the metals for the metal carrier (2) and metal housing (14) are selected from the group comprising copper, iron, aluminium, zinc, nickel and alloys of these materials with a view to achieving good mutual weldability.

6. A process for the production of an electrical component as claimed in one of Claims 1 to 5, wherein the metal carriers (2), together with terminal lugs (4 to 8 and 28), are first punched-out from a continuous metal strip (27) in such a way that a plurality of metal carriers (2) are securely held together by means of a base strip (29) to which the terminal lugs (4 to 8 and 28) remain connected, and by means of connecting parts (30, 31) which, together with the terminal lugs (4) for the earth terminal, produce the connection between the metal carrier (2) and the terminal lugs (5 to 8 and 28), whereafter the synthetic resin component (16) is shaped around the inner terminal elements (32 to 36) of the terminal lugs (4 to 8) and around metal strips (37, 38) on the metal carrier (2) leading to the connecting parts (30, 31) ; previously or afterwards the active component (1) is attached to the metal carrier (2) and by means of wires (9 to 13) is electrically connected to the inner terminal elements (32 to 36) ; then the connecting parts (30, 31) are removed, the housing (14) is placed on the synthetic resin còmponent (16) and is connected thereto by adhesive and/or casting material (17) and tightly sealed ; and finally the terminal lugs (4 to 8 and 28) are separated from the base strip (29) in the appropriate length, characterised in that, during the punching operation and the removal of the connecting parts (30, 31), the bridge from the metal strips (37, 38) of the metal carrier (2) to the connecting parts (30, 31) is so shaped that terminal lugs (21, 22) are formed which are directed towards the inner wall of the metal housing (14) against which they abut after the metal housing (14) is placed in position, or from which they are spaced by a maximum of 0.2 mm, whereupon the electrical connection between the metal housing (14) and the terminal lugs (21, 22) is effected by welding or soldering.

7. A process as claimed in Claim 6, characterised in that the terminal lugs (21, 22) are punched to a length which is such that they project beyond the edge (26) of the metal housing (14) by 0.1 to 0.3 mm and, during the welding operation, they melt and form the connection (23) to the metal housing (14).

## Revendicatons

1. Composant électrique, dont la partie active (1) est disposée sur un support métallique (2), notamment filtre d'ondes de surface comportant au moins un transducteur d'entrée et au moins un transducteur de sortie sur une face d'un corps piézo-électrique (1) notamment monocristallin servant de partie active et qui est fixé par son autre face sur le support métallique (2) devant être raccordé électriquement à la masse et sur un côté longitudinal (3) duquel sont prévues, de manière à s'étendre dans le même plan, au moins une languette de raccordement (4) pour ce raccord de masse et d'autres languettes de raccordement (5 à 8) séparées du point de vue électrique et mécanique et servant à réaliser l'alimentation en courant aboutissant à la partie active (1) ou au prélèvement de courant à partir de cette partie active par l'intermédiaire de fils de jonction (9 à 12), la partie active, notamment le corps piézo-électrique (1), le support métallique (2) et les fils de jonction (9 à 13) étant logés dans un boîtier (14) dont l'ouverture (15) est obturée par une pièce en matière plastique (16) et un matériau (17) constitué par une colle et/ou une masse de scellement, tandis que les languettes de raccordement (4 à 8) font saillie extérieurement à travers la pièce en matière plastique (16), caractérisé par le fait que le boîtier (14) est métallique, que son ouverture (15) fait saillie par-dessus la pièce en matière plastique (16) et que le support métallique (2) se prolonge, au moins au niveau d'une extrémité (19, 20) du côté longitudinal (3), par une languette de raccordement (21, 22) qui est reliée galvaniquement, à l'extérieur de la pièce en matière plastique (16), à la partie saillante (18) du boîtier métallique (14) par une liaison soudée ou brasée (23).

2. Composant électrique suivant la revendication 1, caractérisé par le fait qu'au moins une languette de raccordement (21, 22) est dimensionnée de telle sorte que sa zone de sectionnement (24, 25), produite lors de la fabrication, est appliquée en aboutement contre la paroi intérieure du boîtier métallique (14) ou se situe au maximum à une distance de 0,2 mm de la paroi intérieure.

3. Composant électrique suivant la revendication 1 ou 2, caractérisé par le fait qu'avant le soudage, au moins une languette de raccordement (21, 22) fait saillie d'une distance de 0,1 à 0,3 mm au-delà du bord (26) du boîtier métallique (14).

4. Composant électrique suivant l'une des revendications 1 à 3, caractérisé par le fait qu'au moins

7

**0 061 648**

une languette de raccordement (21, 22) est munie d'un prolongement qui sert de languette de raccordement supplémentaire (28) pour le raccord de masse.

5. Composant électrique suivant l'une des revendications 1 à 4, caractérisé par le fait que les métaux pour le support métallique (2) et pour le boîtier métallique (14) sont choisis parmi le groupe incluant le cuivre, le fer, l'aluminium, le zinc, le nickel ou des alliages de ces métaux, en vue d'obtenir une bonne aptitude au soudage mutuel.

6. Procédé pour fabriquer un composant électrique suivant l'une des revendications 1 à 5, selon lequel on découpe tout d'abord les supports métalliques (2) ainsi que les languettes de raccordement (4 à 8 et 28) à partir d'un feuillard d'un seul tenant (27) de telle sorte que le maintien assemblé de plusieurs supports métalliques (2) est assuré à l'aide d'une bande de base (29) à laquelle les languettes de raccordement (4 à 8 et 28) restent reliées, et par des organes de liaison (30, 31) qui forment avec la languette de raccordement (4) pour le raccord de masse la liaison entre le support métallique (2) et les languettes de raccordement (5 à 8 et 28), on moule ensuite la pièce en matière plastique (16) autour des éléments de raccordement intérieurs (32 à 36) des languettes de raccordement (4 à 8) et autour de bandes métalliques (37, 38) sur le support métallique (2) jusqu'au niveau des organes de liaison (30, 31), on fixe préalablement ou ensuite la partie active (1) du support métallique (2) et on la relie électriquement de façon correspondante, à l'aide de fils (9 à 13), aux éléments de raccordement intérieurs (32 à 36), on enlève ensuite les organes de liaison (30, 31), on place le boîtier (14) sur la pièce en matière plastique (16) et on le relie à cette dernière et on le ferme de façon étanche à l'aide d'un matériau (17) formé d'une colle et/ou d'une masse de scellement, et on dégage de la bande de base (29) les languettes de raccordement (4 à 8 et 28) sur une longueur correspondante, caractérisé par le fait que le passage entre les bandes métalliques (37, 38) des supports métalliques (2) et les organes de liaison (30, 31) est conformée lors du découpage et de la suppression des organes de liaison (30, 31) de telle sorte qu'il se forme des languettes de raccordement (21, 22) qui sont dirigées vers la paroi intérieure du boîtier métallique (14) et s'appliquent en aboutement contre cette paroi, une fois que le boîtier métallique (14) est mis en place ou sont situées au maximum à une distance de 0,2 mm par rapport à cette paroi, à la suite de quoi on réalise la liaison électrique (23) entre le boîtier métallique (14) et les languettes de raccordement (21, 22) par soudage ou brasage.

7. Procédé suivant la revendication 6, caractérisé par le fait que les languettes de raccordement (21, 22) sont découpées avec une longueur telle qu'elles font saillie de 0,1 à 0,3 mm au-delà du bord (26) du boîtier métallique (14) et fondent lors du soudage et établissent la liaison (23) avec le boîtier métallique (14).

FIG 1

FIG 2

FIG 3

FIG 4